**Europäisches Patentamt**

**European Patent Office**

**Office européen des brevets**

(11) Numéro de publication: **0 035 418**
A1

## DEMANDE DE BREVET EUROPEEN

(21) Numéro de dépôt: **81400162.4**

(51) Int. Cl.³: **H 03 L 1/02**

(22) Date de dépôt: **03.02.81**

(30) Priorité: **22.02.80 FR 8003979**

(71) Demandeur: **COMPAGNIE D'ELECTRONIQUE ET DE PIEZOELECTRICITE - C.E.P.E., 101, rue du Président Roosevelt, F-78500 Sartrouville (FR)**

(43) Date de publication de la demande: **09.09.81**
**Bulletin 81/36**

(72) Inventeur: **Helle, Jacques, THOMSON-CSF SCPI 173, bld Haussmann, F-75360 Paris Cedex 08 (FR)**
Inventeur: **Caret, Guy, THOMSON-CSF SCPI 173, bld Haussmann, F-75360 Paris Cedex 08 (FR)**

(74) Mandataire: **Vesin, Jacques et al, "THOMSON-CSF"-SCPI 173, bld Haussmann, F-75360 Paris Cedex 08 (FR)**

(84) Etats contractants désignés: **CH DE GB IT LI NL SE**

(54) Oscillateur à cristal compensé en température.

(57) L'invention se rapporte au domaine des oscillateurs à cristal à régulation de fréquence en fonction de la température.

La boucle de réaction du circuit oscillant comprend un condensateur à capacité électriquement variable (Cv) auquel est appliqué un signal électrique de compensation variable suivant une courbe du troisième degré en fonction de la température, résultant de la différence entre deux signaux de compensation, respectivement principal appliqué en (8) et complémentaire appliqué en (7), créés par deux circuits constitués chacun de trois cellules, comprenant respectivement trois thermistances shuntées, ($RT_1$, $RT_2$, $RT_3$) et ($RT_4$, $RT_5$, $RT_6$) chaque cellule étant spécialisée dans la création d'un signal correspondant à un arc donné de la courbe totale.

Les applications sont notamment du domaine des émetteurs radioélectriques embarqués sur avions.

OSCILLATEUR A CRISTAL COMPENSE
EN TEMPERATURE

La présente invention se rapporte aux oscillateurs à cristal, à régulation de fréquence en fonction de la température. Ces oscillateurs se composent essentiellement d'un amplificateur dont la sortie est connectée à l'entrée à travers un circuit comportant un cristal piézo-électrique oscillant, le gain du système, avec la boucle de réaction ainsi constituée, étant supérieur à l'unité pour satisfaire aux conditions d'auto-oscillation ; la régulation de fréquence en fonction de la température est obtenue en connectant en série avec le cristal, un condensateur de valeur convenable dont la capacité est variable en fonction d'une tension électrique appliquée à ses armatures, et en créant cette tension électrique, habituellement désignée sous le nom de "signal de compensation", dans un circuit de compensation comprenant un élément sensible à la température.

Cependant les circuits de compensation connus ne permettent pas d'obtenir industriellement une complète régulation de fréquence, dans le cas fréquence où le cristal oscillant a été taillé selon une coupe particulière, avantageuse suivant certains aspects, connue sous le nom de AT : pour cette coupe, la dérive thermique $\frac{\Delta f}{f}$ de la fréquence f du cristal affecte en effet la forme d'une courbe algébrique du 3e degré.

Dans ce dernier cas il est ainsi nécessaire de créer un signal de compensation variant également suivant une fonction du 3e degré, solution conduisant à des circuits de compensation, déjà connus, difficiles et coûteux à réaliser, par suite de la précision et de la stabilité élevées exigées par le signal de compensation à obtenir, et des caractéristiques particulières exigées de certains composants, tels que les éléments sensibles à la température ou thermistances.

Dans un brevet français de la demanderesse, déposé sous le numéro 74/30338 et publié sous le numéro 2.284.219, il a été proposé de décomposer la courbe correspondant à la loi de variation du 3e degré du signal de compensation en trois arcs, et d'en assurer la réalisation par trois circuits distincts comprenant chacun un élément sensible à la température.

Pour cela, dans cet oscillateur à cristal constitué d'un circuit oscillant en forme de boucle de réaction, comprenant un amplificateur, un cristal piézo-électrique oscillant et un élément doué de réactance variable en fonction de grandeurs ou signaux électriques, la grandeur ou signal électrique de compensation est créée par un circuit comportant deux bornes, l'une maintenue en fonctionnement à un potentiel fixe par un pont diviseur, l'autre portée à un potentiel variable en fonction de la température, un premier élément et un deuxième élément sensibles à la température étant reliés par une de leurs extrémités à cette autre borne, leur autre extrémité étant respectivement reliée à deux ponts diviseurs, dont l'un comprend un troisième desdits éléments, les trois points étant connectés aux bornes de ladite source d'énergie électrique.

L'oscillateur du brevet cité fournit ainsi au voisinage de 30 MHz une stabilité de fréquence en fonction de la température de l'ordre de $1.10^{-6}$ dans la gamme de températures s'étendant entre $-40°$ et $+80°$.

Cependant, dans certains domaines d'utilisation, tels que celui de l'avionique par exemple, les gammes de températures à couvrir pour les besoins sont encore plus écartées et sont typiquement comprises entre $-55°$ et $+105°$ C ; et le circuit de compensation en température du brevet cité ne permet pas de satisfaire à une telle exigence. La courbe de la tension de correction fournie par ce circuit en fonction de la température présente en effet, respectivement en deça et au delà des températures limites ($-40°$ $+80°$) deux points d'inflexion avec changement de sens de la courbure.

Une solution partielle peut être envisagée, telle qu'une augmentation de la tension d'alimentation du circuit, mais présente l'inconvénient d'augmenter le potentiel aux bornes de la capacité variable en fonction de la tension, donc de diminuer sa sensibilité. De plus, au delà de 70°, les thermistances ont une variation de résistance trop faible en fonction de la température.

L'oscillateur faisant l'objet de la présente invention ne comporte pas ces inconvénients.

Dans son fondement elle substitue, au pont diviseur de valeur fixe du brevet cité plus haut, appliquant en fonctionnement un potentiel fixe à l'une des bornes du circuit de compensation, un pont diviseur de valeur variable en fonction de la température, comprenant, en plus des résistances, des thermistances, et appliquant ainsi à cette borne un potentiel variable constituant une tension de compensation complémentaire.

Ce circuit de compensation complémentaire agit particulièrement aux extrémités de la bande de températures, et ne modifie pas sensiblement la loi de, variation de la tension de compensation dans la gamme médiane des fréquences.

Suivant une variante de réalisation particulièrement avantageuse, le circuit de compensation complémentaire est structurellement constitué des mêmes éléments que le circuit de compensation du brevet cité, ce second circuit étant inversé dans ses bornes de raccordement à la source d'alimentation électrique.

Cette variante procure une amélioration de la courbe de variation de la tension de compensation pour la gamme médiane des fréquences.

Plus précisément, l'invention concerne un oscillateur à cristal à régulation de fréquence dans un grand domaine de températures, constitué d'une part d'un circuit oscillant en forme de boucle de réaction, comprenant un amplificateur, un cristal piézo-électrique oscillant, et une capacité variable en fonction de tensions électriques, et d'autre part d'un circuit de compensation en deux parties, connectées aux bornes d'une source d'énergie électrique continue, chaque partie comportant des éléments dont la résistance électrique dépend de la température, circuit délivrant à ses bornes un signal de compensation appliqué à la capacité variable, l'une des bornes étant portée à un potentiel de compensation principal par une partie principale du circuit, constituée d'un premier et d'un second desdits éléments, reliés par une de leurs extrémités à cette borne, leur autre extrémité étant respectivement reliée à deux ponts diviseurs dont l'un comprend un troisième desdits éléments, les deux ponts étant connectés aux bornes de ladite source, caractérisé en ce que l'autre des bornes est portée à un potentiel de compensation complémentaire par l'autre partie du circuit de compensation, ledit signal de compensation résultant de la différence entre lesdits potentiels principal et complémentaire.

L'invention sera mieux comprise à l'aide de la description ci-après, en s'appuyant sur les figures annexées, où :

- la figure 1 représente, suivant une vue schématique, le circuit de compensation selon l'art connu ;

- la figure 2 représente la courbe de variation de la tension de compensation en fonction de la température, fournie par le circuit de la figure 1 ;

- la figure 3 représente, suivant une vue schématique partielle, le circuit de compensation complémentaire selon l'invention ;

- la figure 4 représente, suivant deux parties (a) (b), deux diagrammes explicatifs, en axes rectangulaires correspondant aux deux cas précédents ;

- la figure 5 représente, suivant deux parties (a) (b), deux diagrammes explicatifs, en axes rectangulaires, correspondant aux deux cas précédents ;

- la figure 6 représente, en trois parties (a) (b), et (c), trois diagrammes en axes rectangulaires, donnant en (c) les courbes de variation de la tension de compensation finale, par comparaison avec les courbes (a) (b) de compensation principale et complémentaire ;

- la figure 7 représente une variante du circuit de compensation selon l'invention, comportant deux circuits inversés ;

- la figure 8 représente, dans des axes rectangulaires, la courbe de la tension délivrée par le circuit de compensation complémentaire ;

- la figure 9 représente, dans des axes rectangulaires, la courbe de la tension de compensation totale résultant de la différence des deux tensions de compensation principale et complémentaire.

- la figure 10 représente une autre variante de réalisation du circuit de compensation selon l'invention.

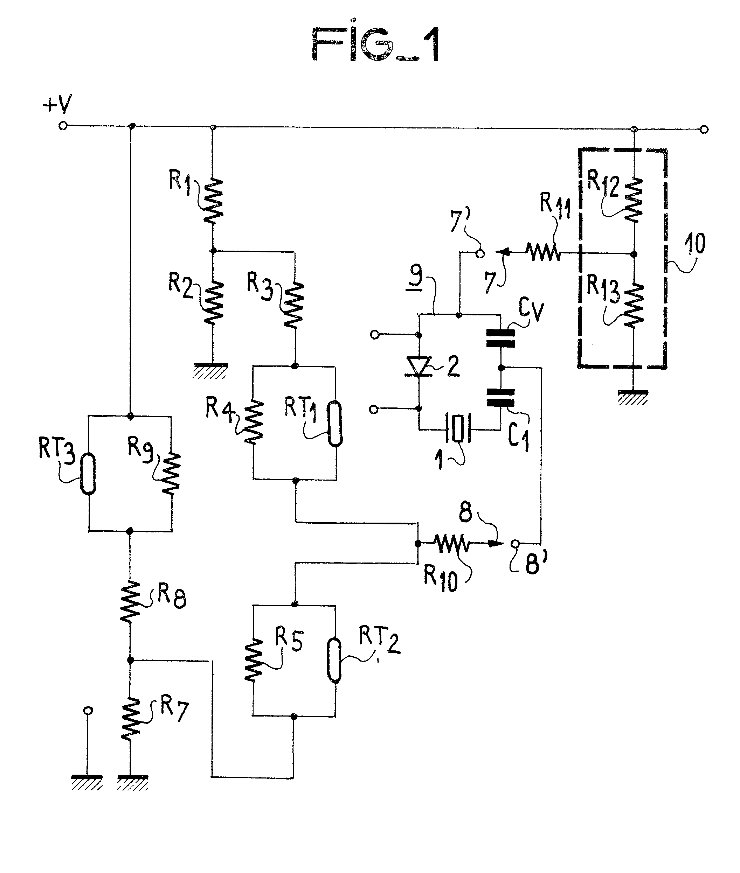

La figure 1 représente, suivant une vue schématique, le circuit de compensation selon le brevet cité de l'art connu.

L'oscillateur, représenté symboliquement par le bloc 9, est constitué, de façon connue, d'une boucle de réaction comprenant un cristal piézo-électrique 1, et un amplificateur 2, deux éléments capacitifs $C_1$ et $C_V$ déterminant, avec le cristal, la fréquence d'oscillation par réaction. L'un des condensateurs $C_V$ est du type connu sous le nom de varicap, et sa valeur varie suivant la valeur d'une tension continue appliquée à ses bornes, représentées sur la figure en 7' et 8'. Les tensions de commande de ce condensateur sont créées à ses bornes par les sorties 7 et 8 du circuit de compensation dont la sortie 8 délivre une tension $e_8$ variable en fonction de la température, la tension $e_7$ de la sortie 7 étant de valeur constante, et créée par le pont diviseur 10 encadré en tirets.

La différence de potentiel, ($e_8$ - $e_7$) entre les sorties 8 et 7 modifie la valeur de la capacité du condensateur de type varicap, et par conséquent, pour des valeurs convenables des éléments du réseau de compensation, peut compenser les variations de la fréquence délivrée par l'oscillateur à cristal en fonction de la température.

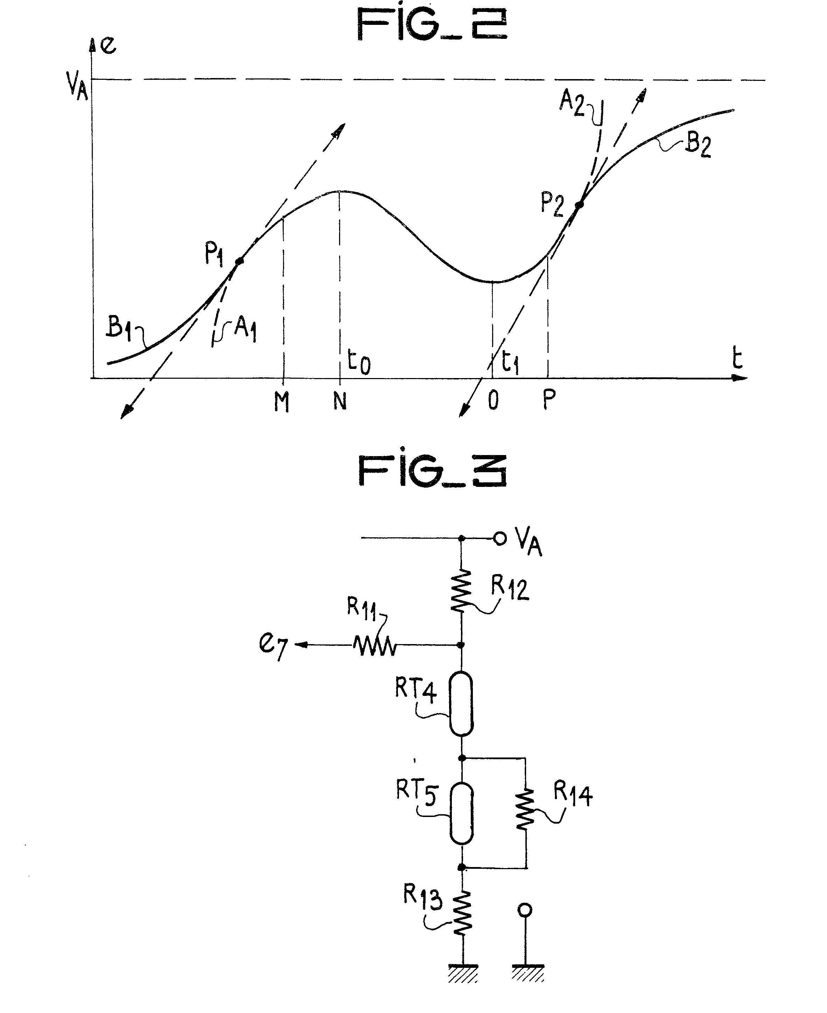

La figure 2 représente, suivant un diagramme en axes rectangulaires, la courbe de variation de la tension de compensation en fonction de la température fournie par le circuit de l'art connu de la figure 1.

Cette courbe, où en abscisses sont portées les températures et en ordonnées les tensions de compensation, présente, vers les deux extrémités de la gamme des températures, deux points d'inflexion P1, P2, en deça et au delà desquels il n'est plus possible d'obtenir la compensation, les arcs de courbe nécessaires $A_1$, $A_2$ étant remplacés par les arcs de courbe $B_1$ $B_2$.

Dans l'art connu on se trouve donc limité à un écart de températures compris à l'intérieur de celui qui est défini par les points d'inflexion, ce qui, en pratique, représent les limites (-40° + 80°).

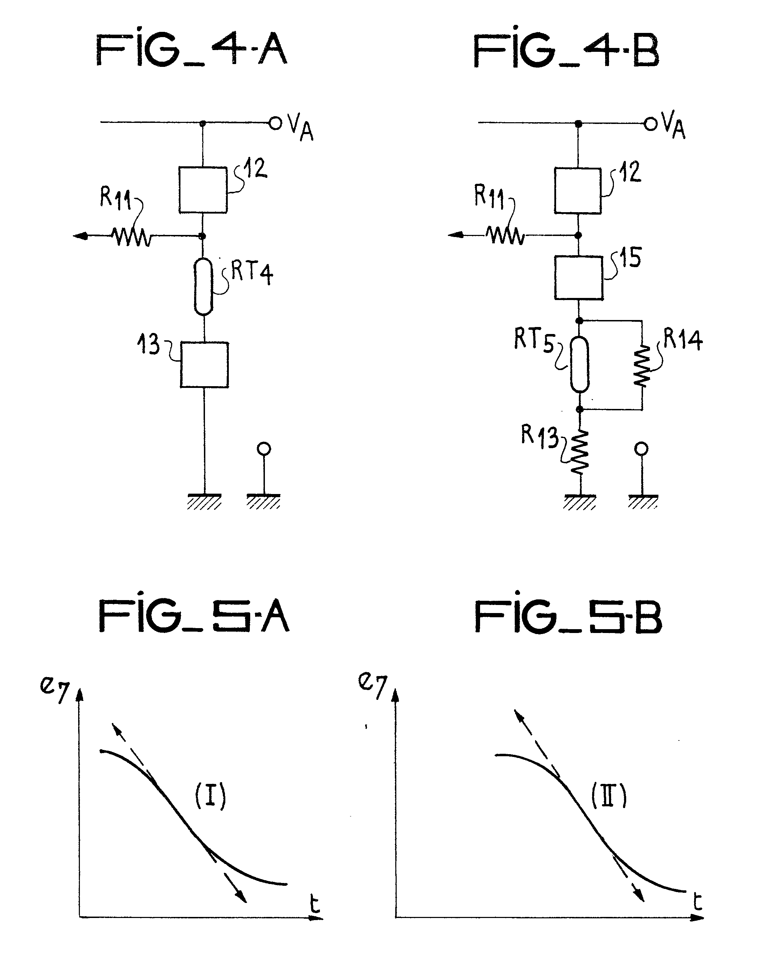

La figure 3 représente, suivant une vue schématique partielle, le circuit de compensation complémentaire suivant l'invention. Ce circuit, qui se substitue au pont diviseur encadré en tirets 10 du brevet cité, a pour rôle de créer une tension $e_7$ variable en fonction de la température, suivant une loi de variation telle que la tension de compensation e = $e_8$ - $e_7$ appliquée au condensateur de type varicap présente ses points d'inflexion néfastes $P_1$ $P_2$ pour des valeurs de température nettement plus écartées que dans l'art connu.

Le circuit comporte, par rapport au pont diviseur $R_{12}$ $R_{13}$ de la figure 1, deux thermistances $RT_4$ et $RT_5$ en série dans la branche de $R_{13}$ reliée à la borne négative de la source d'énergie électrique d'alimentation, l'une des deux thermistances $RT_5$ étant shuntée par une résistance $R_{14}$.

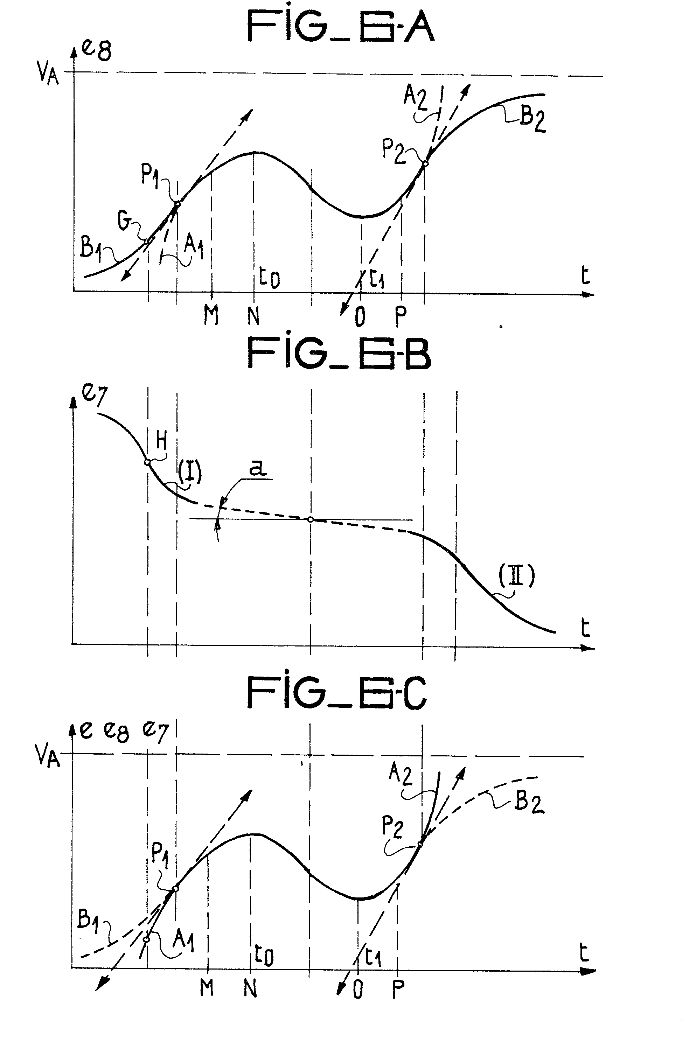

Le fonctionnement d'un tel circuit de compensation complémentaire peut être suivi sur les figures 4 et 5.

La figure 4 représente, suivant deux parties (a) et (b), deux dessins explicatifs du fonctionnement aux basses et aux hautes températures.

Aux basses températures, la valeur de la thermistance $RT_5$ est très grande devant la valeur de la résistance $R_{14}$. Le circuit peut donc être représenté comme en (a), où les blocs 12 et 13 représentent les éléments non variables en fonction de la température.

Aux limites, pour $RT_4$ infinie, $e_7$ prend une valeur proche de $V_A$ ; pour $RT_4$ nulle, $e_7 = \dfrac{V_A \times 13}{12 + 13}$.

Cette variation de $e_7$ est donnée sur la figure 5, sur la courbe en axes rectangulaires (a),repérée I.

Aux températures élevées, la valeur de la thermistance $RT_4$ est négligeable par rapport à la valeur des autres éléments du circuit.

Le circuit peut donc être représenté comme en (b), où les blocs 12 et 15 représentent les éléments non variables en fonction de la température.

Comme plus haut, les valeurs limites pour $RT_5$ respectivement infini et nul donnent les limites de variation de la tension $e_7$.

Cette variation de $e_7$ est donnée sur la figure 5, sur la courbe en axes rectangulaires (b), reprérée II.

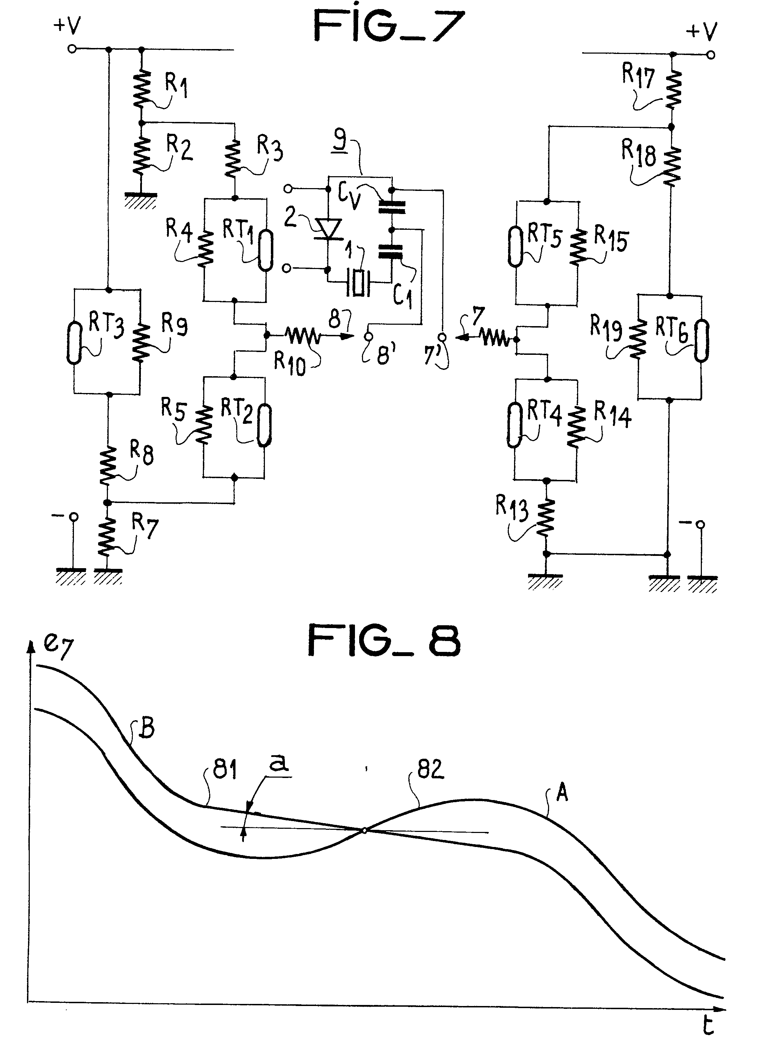

La figure 6 représente, suivant trois diagrammes (a) (b) (c) en axes rectangulaires, les variations de la tension de compensation finale (c), par comparaison avec les courbes (a) (b) de compensation respectivement principale et complémentaire.

La courbe (a) est analogue à celle de la figure 2, et est celle de la tension de compensation $e_8$ fournie par le circuit du brevet principal.

La courbe (b) est celle de la tension de compensation $e_7$ qui est fournie par le circuit de compensation complémentaire de la figure 3. Cette courbe comprend les arcs extrêmes qui ont été décrits plus haut, disposés de part et d'autre de la partie centrale, où le circuit de la figure 3 n'influe que très peu ; sa seule influence ne se manifeste que par une pente $\underline{a}$ de la courbe, dans le sens des diminutions vers les températures élevées.

La courbe (c) représente la tension de compensation finale ($e_8$ - $e_7$) appliquée sur le condensateur de type "varicap" de l'oscillateur. Cette tension $\underline{e}$ est représentée graphiquement, à une longueur constante près, par la longueur du segment GH déterminé sur une droite verticale, par l'intersection avec les deux courbes (a) et (b). On constate que la courbe (c) ne présente plus de points d'inflexion aux extrémités de la gamme de températures et que ses centres de courbure y sont toujours du même côté de la tangente. La courbe de compensation globale satisfait donc aux conditions indiquées plus haut pour l'extension du domaine de températures où la compensation est assurée.

A titre d'ordre de grandeur typique, la gamme de températures où la compensation est assurée s'étend alors pour une compensation a $\pm$ 1.10$^{-6}$ de la fréquence de - 55° à + 105°.

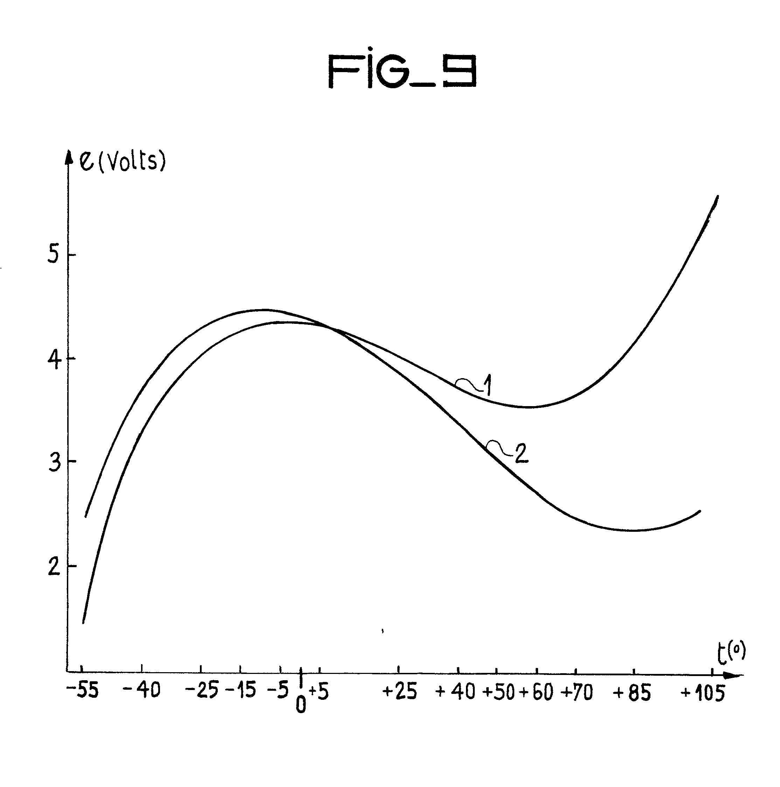

La figure 7 représente une variante de réalisation particulièrement avantageuse du circuit de compensation complémentaire faisant l'objet de la présente invention. Les résultats procurés par ce circuit peuvent être observés sur le diagramme en axes rectangulaires de la figure 8.

Le circuit de compensation complémentaire de la figure 3 crée, ainsi qu'on l'a indiqué plus haut, une pente de faible valeur dans la partie médiane de la courbe des tensions de compensation représentée sur la figure 6, qui dans certaines applications est à éviter.

La variante de la figure 7 ne crée pas de pente dans cette partie médiane.

Elle est constituée par un circuit de compensation complémentaire qui, selon l'invention, est identique dans sa structure au circuit de compensation du brevet cité, mais est inversé dans son mode de raccordement avec la source d'alimentation électrique. Les valeurs des éléments dont il est constitué sont déterminées pour que la tension de compensation complémentaire créée $e_7$ ne soit qu'une fraction de la tension de compensation principale $e_8$.

La figure 8 représente, dans des axes rectangulaires, la courbe A de la tension de compensation complémentaire $e_7$ obtenue, en fonction des températures aux bornes du circuit inversé de la figure 7. On peut y remarquer que, par rapport à la courbe correspondante B représentée, en tirets obtenue avec le mode de réalisation de la figure 3, la pente a de la courbe dans la partie médiane 81 est remplacée par une partie légèrement ondulée 82, qui se rapproche avantageusement d'un palier horizontal plus favorable dans certaines utilisations.

La figure 9 représente, dans des axes rectangulaires, les variations de la tension de compensation totale $e = e_8 - e_7$ obtenues dans les cas respectifs du circuit de compensation de l'art connu, (courbe), et des deux circuits de compensation de la présente invention (courbes 2 et 3). On peut remarquer que pour les mêmes limites de température, à savoir - 55° à + 105°, les variations de tension e à réaliser pour la compensation sont beaucoup plus réduites dans le cas de l'invention, typiquement de $2,369^V$ à $4,425^V$, que dans le cas de l'art connu, typiquement $1,499^V$ à $5,662^V$.

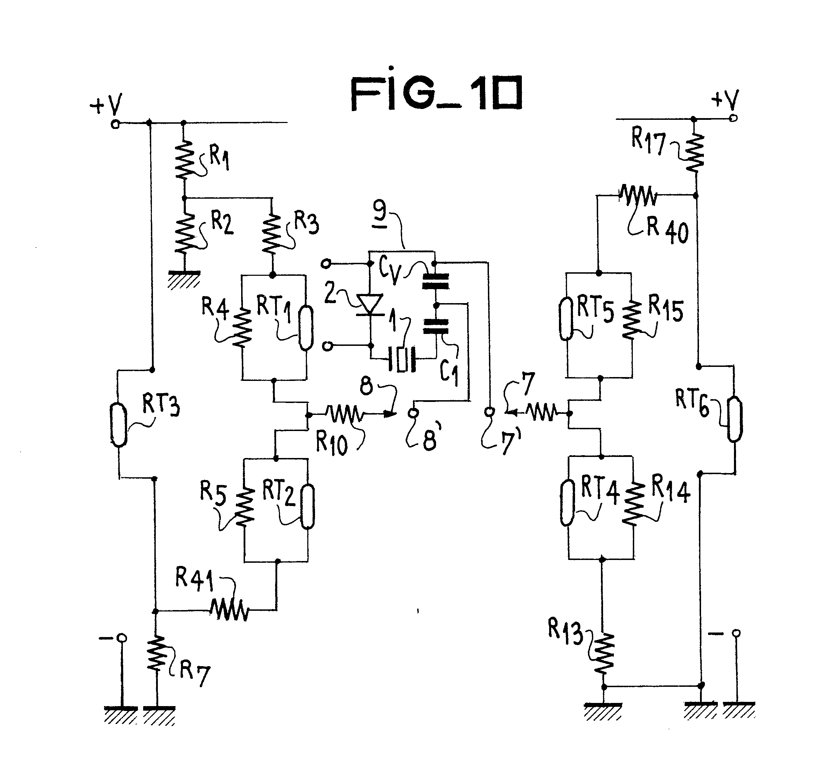

La figure 10 montre le meilleur exemple de réalisation d'un circuit de compensation selon l'invention, donnant les résultats montrés sur la figure 8.

Sur cette figure, les mêmes éléments que ceux des figures précédentes portent les mêmes références. Le circuit représenté sur cette figure, comparativement à celui représenté sur la figure 7, possède les modifications suivantes : les résistances $R_9$ et $R_{19}$ ont été supprimées tandis que les résistances $R_8$ et $R_{18}$ ont été court-circuitées. Les résistances $R_{41}$ et $R_{40}$ ont été respectivement introduites entre le point commun d'une part aux résistances $R_7$, $RT_3$ et $R_5$, $RT_2$, et d'autre part au point commun aux résistances $R_{17}$, $RT_6$ et $RT_5$, $R_{15}$. De cette façon, on obtient des résultats supérieurs à ceux du circuit représenté sur la figure 7, dans le but de stabiliser la fréquence des oscillations dans une large gamme de température.

10

## REVENDICATIONS

1. Oscillateur à cristal à régulation de fréquence dans un grand domaine de températures, constitué d'une part d'un circuit oscillant (9) en forme de boucle de réaction, comprenant un amplificateur (2), un cristal piézo-électrique oscillant (1), et une capacité variable $C_V$ en fonction de la tension électrique appliquée à ses bornes et d'autre part d'un circuit de compensation qui engendre une tension de commande, variable en fonction de la température, aux bornes de la capacité variable $C_V$, ledit circuit de compensation comportant deux parties, respectivement principale et complémentaire, connectées chacune à l'une de leurs extrémités à l'une des bornes d'une source de tension électrique et à l'autre de leurs extrémités à l'une des bornes (7', 8') de la capacité variable $C_V$, le circuit de compensation principal délivrant un potentiel de compensation principal à la borne (8') de la capacité variable $C_V$, variant selon une fonction du 3ème. degré de la température, caractérisé en ce que l'autre borne (7') de la capacité variable $C_V$ est portée à un potentiel de compensation complémentaire variable en fonction de la température, délivré par le circuit de compensation complémentaire, la différence entre les potentiels de compensation principal et complémentaire variant également selon une fonction du troisième degré.

2. Oscillateur à cristal selon la revendication 1, caractérisé en ce que le circuit de compensation complémentaire délivre également un potentiel de compensation variant selon une fonction du troisième degré.

3. Oscillateur à cristal selon l'une des revendications 1 ou 2, caractérisé en ce que le circuit de compensation principal comporte notamment un premier et un second éléments dont la résistance électrique varie en fonction de la température, reliés par une de leurs extrémités à la borne (8') et dont l'autre extrémité est respectivement reliée l'une à un potentiel fixe et l'autre à un potentiel variable en fonction de la température.

4. Oscillateur à cristal selon la revendication 3, caractérisé en ce que le potentiel variable est créé par un pont de résistance dont l'une des branches comporte un troisième élément dont la résistance électrique varie en fonction de la température.

5. Oscillateur à cristal selon l'une des revendications 1 à 4, caractérisé en ce que le circuit de compensation complémentaire est constitué d'un pont diviseur de valeur variable avec la température.

6. Oscillateur à cristal selon l'une des revendications 1 à 5, caractérisé en ce que le circuit de compensation complémentaire ne comporte que des résistances et des thermistances.

7. Oscillateur à cristal selon l'une des revendications 1 a 6, caractérisé en ce que la partie complémentaire du circuit de compensation est constituée d'un pont diviseur à deux branches, dont l'une des branches, reliée à la borne positive de la source d'énergie électrique, comporte une résistance de valeur fixe, et l'autre branche comporte une chaîne de trois résistances connectées en série, dont deux du type thermistance, la thermistance intermédiaire de la chaîne étant shuntée, et dont la troisième, de valeur fixe, est reliée à la borne négative de masse de la source, les deux thermistances, shuntée et non shuntée, assurant respectivement au potentiel de compensation secondaire, dans sa gamme de variation en fonction des températures croissantes, des valeurs décroissantes pour les extrémités respectivement haute et basse de ladite gamme.

8. Oscillateur à cristal selon l'une des revendications 3 à 7, caractérisé en ce que chacun des trois éléments sensibles à la température de la partie principale du circuit est respectivement relié à une résistance connectée en parallèle à ses extrémités.

9. Oscillateur à cristal selon l'une des revendications 1 à 8, caractérisé en ce que chacune des bornes du circuit de compensation est reliée à celui-ci à travers une résistance de valeur élevée devant celle des ponts diviseurs.

10. Oscillateur à cristal selon l'une des revendications 1 à 9, caractérisé en ce que la partie complémentaire du circuit de compensation est structurellement identique à la partie principale, les bornes de la source d'énergie électrique continue leur étant respectivement connectées avec leurs polarités inversées.

11. Oscillateur à cristal selon l'une des revendications 1 à 10, caractérisé en ce que le cristal oscillant a été taillé selon une coupe AT.

FIG_1

# FIG_2

# FIG_3

# FIG_4·A

# FIG_4·B

# FIG_5·A

# FIG_5·B

0035418

## FIG_6·A

## FIG_6·B

## FIG_6·C

FIG_8

0035418

FIG_9

FIG_10

**Office européen des brevets**

**RAPPORT DE RECHERCHE EUROPEENNE**

0035418

Numéro de la demande

EP 81 40 0162

## DOCUMENTS CONSIDERES COMME PERTINENTS

| Catégorie | Citation du document avec indication, en cas de besoin, des parties pertinentes | Revendication concernée |
|---|---|---|
| | FR - A - 1 534 232 (INTERNATIONAL STANDARD ELECTRIC)<br>* Page 1, colonne de gauche, ligne 1 - page 3, colonne de gauche, ligne 15; figure 4 * | 1,3,5-7,10,11 |
| | -- | |
| | US - A - 4 107 629 (STONE)<br>* Colonne 1, ligne 63 - colonne 7, ligne 24; figures 1,2 * | 1,5-8,10 |
| | -- | |
| DA | FR - A - 2 284 219 (C.E.P.E.)<br>* Page 1, ligne 1 - page 7, ligne 29; figures 3-7 * | 1,3-6,8,9 |
| | -- | |
| P | GB - A - 2 038 125 (NIPPON ELECTRIC)<br>* Page 1, ligne 55 - page 4, ligne 39; figure 1 * | 1,3,5,6,8 |
| | ---- | |

**CLASSEMENT DE LA DEMANDE (Int. Cl.³)**

H 03 L 1/02

**DOMAINES TECHNIQUES RECHERCHES (Int. Cl.³)**

H 03 L 1/02
H 03 B 5/32
         5/36
         5/04

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 27-05-1981 | DHONDT |

OEB Form 1503.1  06.78